# EUROPEAN PATENT SPECIFICATION

(11) **EP 1 105 965 B1**
(45) Date of publication and mention of the grant of the patent: **18.12.2002**
(21) Application number: 99957122.7
(22) Date of filing: 09.06.1999
(51) Int. Cl.: H03B 5/18, G01S 7/03

(54) **OSCILLATOR CIRCUIT**
OSZILLATORSCHALTUNG
CIRCUIT D'OSCILLATEUR

(30) Priority: 16.06.1998 GB 9812936; 16.06.1998 US 98267
(43) Date of publication of application: 13.06.2001
(73) Proprietor: Microwave Solutions Limited, Borehamwood, Hertfordshire WD6 1RX (GB)
(72) Inventor: HALLATT, John, Gilbert, Berkhamstead, Herts HP4 2SD (GB); ALDRED, Ian, Richard, Rickmansworth, Herts WD3 3JY (GB)
(74) Representative: Hutchinson, Glenn Stanley
(86) International application number: GB9901667
(87) International publication number: WO99066635

(56) References cited:
- EP-A- 0 836 271
- US-A- 4 754 236
- US-A- 5 497 163
- LEE J Y ET AL: "VOLTAGE CONTROLLED DIELECTRIC RESONATOR OSCILLATOR USING THREE- TERMINAL MESFET VARACTOR" ELECTRONICS LETTERS, vol. 30, no. 16, 4 August 1994 (1994-08-04), page 1320/1321 XP000468811 ISSN: 0013-5194
- ELAAD D: "VOLTAGE CONTROLLED OSCILLATOR STABILIZED BY A DIELECTRIC RESONATOR" PROCEEDINGS OF THE CONFERENCE OF ELECTRICAL AND ELECTRONICS ENGINEE IN ISRAEL, TEL AVIV, APR. 7 - 9, 1987, no. CONF. 15, 7 April 1987 (1987-04-07), pages 1-3, XP000124841 INSTITUTE OF ELECTRICAL AND ELECTRONICS ENGINEERS
- BATTIBOIA S ET AL: "LOW-POWER X-BAND RADAR FOR INDOOR BURGLAR ALARMS" IEEE TRANSACTIONS ON MICROWAVE THEORY AND TECHNIQUES, vol. 43, no. 7, PART 02, 1 July 1995 (1995-07-01), pages 1710-1714, XP000514156 ISSN: 0018-9480
- INOUE T ET AL: "60GHZ DIELECTRICALLY STABILLIZED MONOLITHIC VOLTAGE CONTROLLED OSCILLATOR" PROCEEDINGS OF THE 25TH. EUROPEAN MICROWAVE CONFERENCE 1995, BOLOGNA, SEPT. 4 - 7, 1995, vol. 1, no. CONF. 25, 4 September 1995 (1995-09-04), pages 281-284, XP000740166 EUROPEAN MICROWAVE CONFERENCE COMMITTEE ISBN: 1-899919-15-5

## Description

The present invention relates to an oscillator circuit, and more particularly to a tunable microwave oscillator and to motion detectors which utilise such oscillators.

Typically, an electronically tunable microwave oscillator can utilise a reverse biased varactor having a capacitance which varies according to a corresponding variation in an applied reverse modulation voltage. In order to effect a change in varactor capacitance, and hence to utilise the varactor as a practical frequency tuning device, a modulating signal of high magnitude is required. Typically, at a frequency of oscillation of about 10GHz, a variation of 30V in the applied reverse modulating voltage brings about a corresponding variation of about 20MHz in the frequency of oscillation of a tunable microwave oscillator utilising such a varactor. The frequency range over which the frequency of oscillation of a tunable microwave varactor oscillator can be varied is governed, in part, by the degree of capacitance change of the varactor over the range over which the modulating voltage is varied. A varactor oscillator is illustrated and described in "Dielectric Resonators" published by Artech House and in GB2307355A. The relationship between the degree of frequency modulation and applied modulating signal is only linear for varactors over a narrow percentage bandwidth of up to 3%. Further, relatively large reverse biasing voltages are required for varactor oscillators in order to realise sufficient Q to establish and sustain oscillation. A typical biasing voltage is of the order of 20v to 30v. At these voltages the tuning range available is very limited. The above renders the use of varactors undesirable for low noise oscillators.

"Voltage Controller Dielectric Resonator Oscillator Using Three-Terminal MESFET Varactor", Electronic Letters, vol 30, no. 16, 4 August 1994, page 1320/1321, XP000468811 ISSN: 0013-5194 discloses a voltage controlled dielectric resonator oscillator having a resonant circuit that is electromagnetically coupled to a dielectric resonator thereby forming a pair of mutually coupled resonant circuits. By varying the MESFET varactor capacitance with a bias voltage, the resonant frequency of the dielectric resonator can be tuned.

It is an object of the present invention to at least mitigate some of the problems associated with prior art tunable microwave oscillators, preferably, for use in motion detectors.

Accordingly, the present invention provides an oscillator circuit comprising first and second mutually electro-magnetically couplable resonant circuits, the second resonant circuit comprising a dielectric element and excitation means operable to produce a first frequency of oscillation, the first resonant circuit comprising the dielectric element and excitation means, including a Schottky diode operable in a forward bias mode, responsive to an applied signal, to vary the resonant frequency of the first resonant circuit and thereby vary the first frequency of oscillation of the oscillator circuit.

Operating the Schottky diode in forward bias mode produces a relatively large variation in frequency in response to a relative small variation in modulating voltage. Furthermore, the voltages required to operate a Schottky based oscillator are significantly less than those required to operate a varactor based oscillator.

Preferably, an embodiment of the present invention provides an oscillator circuit wherein the modes of resonance have associated coupling points on the excitation means and the excitation means is arranged such that the coupling points are a substantially constant distance from the dielectric element.

A further embodiment of the invention provides an oscillator circuit wherein the dielectric element comprises an arcuate profile and said excitation means is arranged to follow substantially the arcuate profile of the dielectric element.

Preferably, the excitation means comprises excitation strip lines or microstrip lines.

Embodiments of the present invention will now be described, by way of example only, with reference to the accompanying drawings in which:
figure 1 illustrates schematically a typical transmit-receive arrangement of a motion detector;
figure 2 shows schematically a prior art oscillator for a motion detection device;
figure 3 depicts schematically an oscillator for a motion detection device according to an embodiment;
figure 4 illustrates the antenna patches of a microwave detector;
figure 5 shows a ground plane having two antenna coupling slots for the microwave detector as is also illustrated in WO 92/09905;
figure 6 depicts the microwave detector microstrip circuitry disposed on the opposite side of the board bearing the ground plane; and
figure 7 illustrates the microwave detectors microstrip circuitry having the components disposed thereon.

The use of the doppler effect for detecting motion is well known within the art. For example, in microwave intruder detection devices it is known to provide a dielectric resonator oscillator and diode mixer, mounted in a cavity, which are arranged to provide an output or transmit signal at a required frequency and an input or receive signal, together with a doppler IF output.

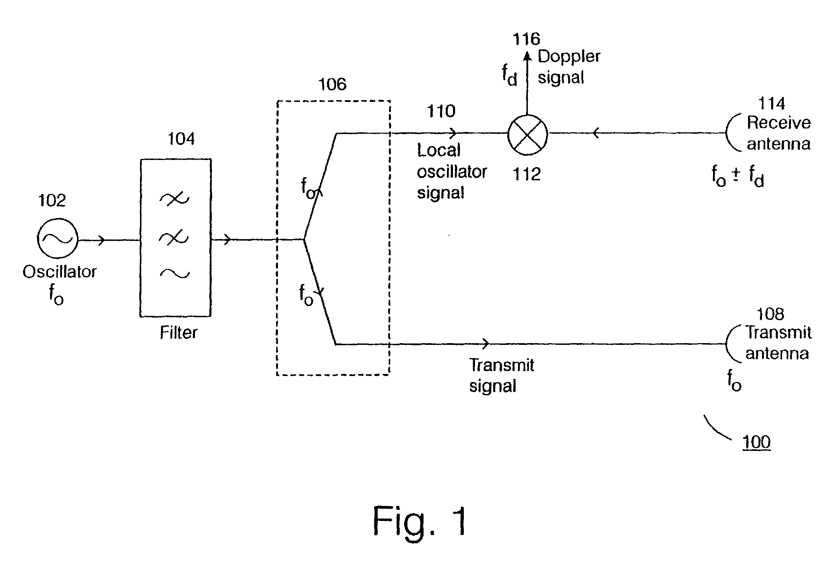

Referring to figure 1, there is shown schematically a microwave circuit 100 having oscillator 102 producing an output frequency fₒ connected to a filter 104 arranged to pass the fundamental frequency of the oscillator, fₒ, and to block the second and higher order harmonics thereof. The output from the filter 104 is fed to a power divider 106 to produce a transmit signal and a local oscillator signal. A transmit antenna 108 is used to radiate the transmit signal. The local oscillator signal 110 is fed to a mixer 112. The mixer 112 has an input from the receive antenna 114 arranged to receive the reflected signal. As is well appreciated within the art if the received signal was reflected from a moving object, it will be a doppler shifted version of the transmit signal. The mixer 112 combines the local oscillator signal with the received signal received by a receive antenna 114. The output 116 from the mixer 112 contains the doppler frequency produced by the reflection of the transmit signal of frequency fₒ from a moving body (not shown). The presence or absence of the doppler signal at the output 116 determines whether or not a moving object has been detected.

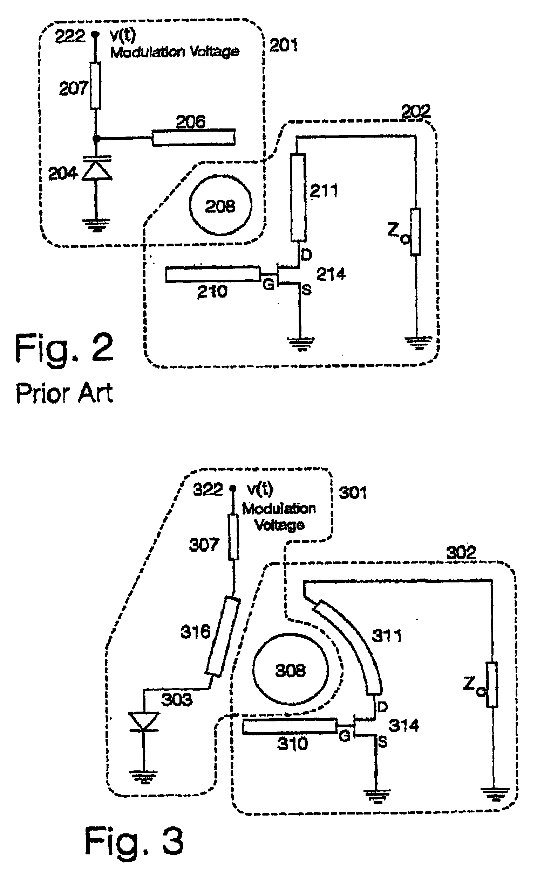

Referring to figure 2, there is shown schematically a prior art embodiment for a motion detector circuit having an oscillator 102 comprising first 201 and second 202 mutually coupled resonant circuits. The first resonant circuit 201 of the oscillator 102 arrangement shown in figure 2 is a varactor 204 in conjunction with a microstrip line 206 arranged to resonate close to the frequency of operation of a dielectric resonator 208.

The second resonator circuit 202 comprises the dielectric resonator 208 electromagnetically coupled, in use, to a further microstrip line 210 connected to the gate of field effect transistor 214 and a microstrip line 211 connected to the drain of field effect transistor 214 and which forms part of the feedback loop of the oscillator. The FET 214 utilises various impedances which are arranged to correctly match the FET 214.

By varying or modulating the varactor capacitance with an applied voltage 222, the resonant frequency of resonant circuit 201, can be tuned resulting in a change of oscillation frequency of the resonant circuit 202.

It will be appreciated by one skilled in the art that the closer the electromagnetic coupling between the dielectric resonator and the microstrip lines, the greater the resultant frequency control. This increased frequency control is at the expense of decreased oscillator Q factor.

With reference to figure 3, there is shown an oscillator circuit for a microwave detector according to an embodiment of the present invention. The oscillator 300 comprises first 301 and second 302 mutually coupled resonant circuits.

The first resonant tuning circuit 301 consists of a microstrip line 316 which has a Schottky diode 303 connected at one end, and a modulation voltage 322, v(t), applied via resistor 307, to the other end of said microstrip line. The tuning line 316 is situated adjacent to the dielectric resonator 308 so that, in use, the dielectric resonator 308 and the tuning line 316 are electromagnetically coupled.

Electronic frequency tuning of the oscillator 300 is achieved by varying the modulation voltage 322, which causes the junction capacitance of the Schottky diode 303 to vary. The change in capacitance brings about a change in the effective length of the tuning line 316 thereby altering the resonant frequency of the tuning line 316. Since the first resonant tuning circuit 301 is mutually coupled to the second resonant circuit 302 via the dielectric resonator 308, the oscillation frequency of the oscillator 300 also varies according to the variation of the modulation voltage 322.

Preferably, the Schottky diode is a BAT15-03W available from Siemens operable at a diode voltage of close to OV. Under such operating conditions the variation in capacitance is as shown in table 1 below.

**TABLE 1**

| V_{F}/V | C/ff |
|---|---|
| -0.05 | 241 |
| 0.00 | 245 |
| +0.05 | 252 |

It will be appreciated that an increase in forward voltage from OV to 0.05V brings about a 2.9% increase in capacitance.

In the present oscillator embodiment a DC voltage is applied to the Schottky diode 303 (connected in forward bias) via resistor 307. Typically, the frequency of the oscillator 300 is shifted by -12MHz from a nominal frequency of 10.525GHz, at an applied tuning voltage 322 of +5V. The frequency shift may be changed by altering the coupling to the dielectric resonator 308.

For comparison, a typical prior art varactor-tuned oscillator operating at a frequency of 10GHz requires a variation of up to 30V in the modulating voltage in order to produce a frequency shift of 20MHz.

The Schottky diode 303 is operated in a forward bias mode. This is in contrast to the varactor 204 of figure 2 which is operated in reverse bias. The higher degree of change in junction capacitance of the Schottky diode 303 at small forward voltages is capitalised on, resulting in a relatively large change in effective length of tuning line 316, and hence large frequency shift of the oscillator 300. The complete tunable oscillator 300 may thus be operated with voltages which are of significantly smaller magnitude as compared to the voltages used in conventional varactor-tuned oscillator 102. A significant reduction in component and circuit cost thus results.

Although figure 3 shows the use of a single Schottky Diode, the present invention is not limited thereto. It will be appreciated by one skilled in the art that diodes or diode pairs could equally well be utilised to realise an embodiment of the present invention. Furthermore, embodiments can also be realised in which the microstrip lines are arcuate as opposed to being straight. Still, further it will be appreciated that the position of the circuit elements depicted in figure 3 et seq are not fixed and can be suitably repositioned without departing from the scope of the present invention. It will also be appreciated by one skilled in the art that there are many other possible oscillator topologies which can be realised using the present invention.

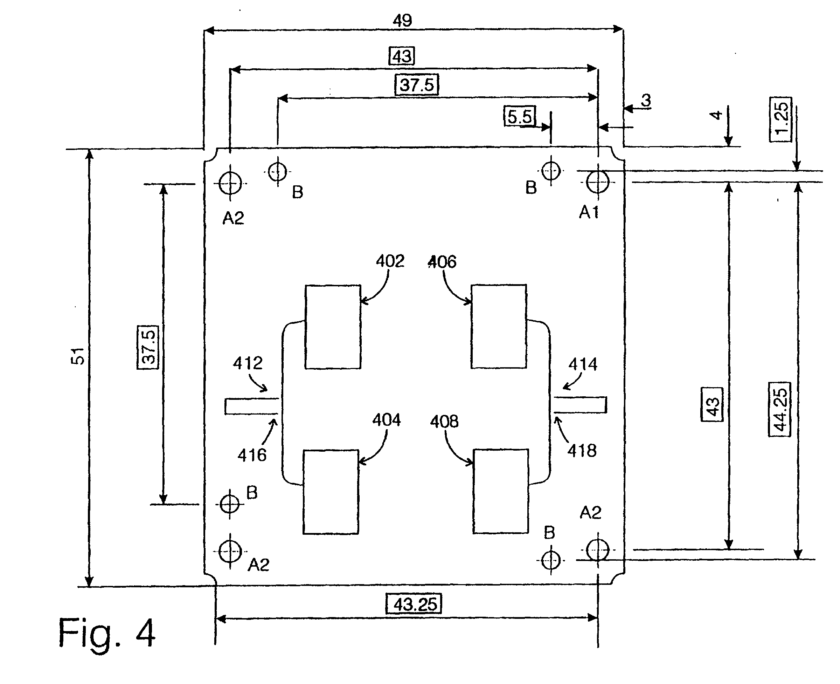

Figure 4 shows the antenna circuit board 400 which can be of singe-sided construction and carries separate transmit and receive antenna arrays. The transmit antenna array comprises two microstrip patch elements, 406 and 408, which are interconnected and connected to a common feed line 418. The receive antenna array also comprises two microstrip patch elements, 402 and 404, which are interconnected and connected to a common feed line 416. Various 2.2 mm holes B are provided to aid the positioning of the antenna board 400 to or on a suitable housing (not shown). Four 3 mm holes A1 and A2 are provided secure the antenna board 400 to or within the housing (not shown). All dimensions are shown in millimetres.

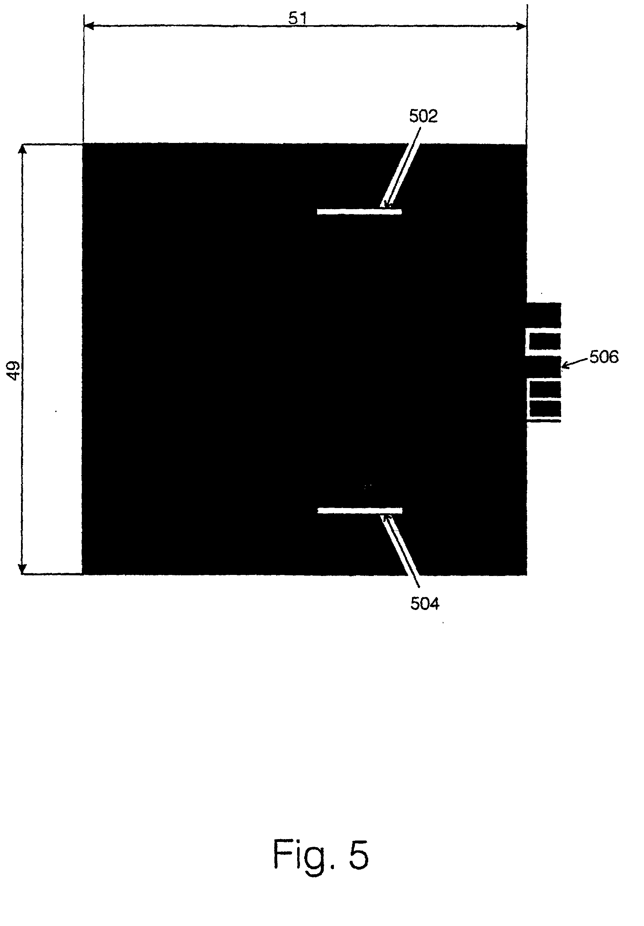

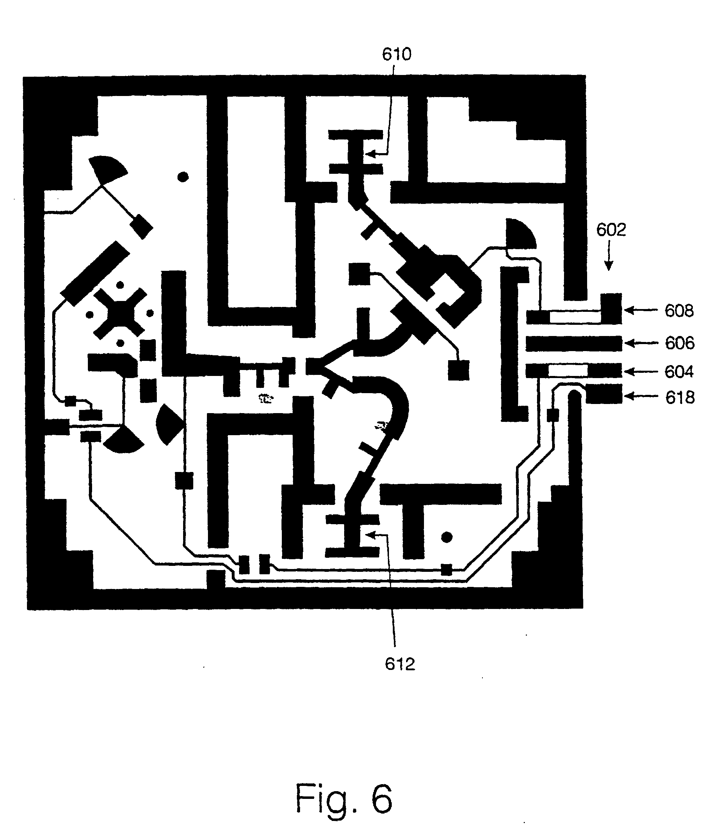

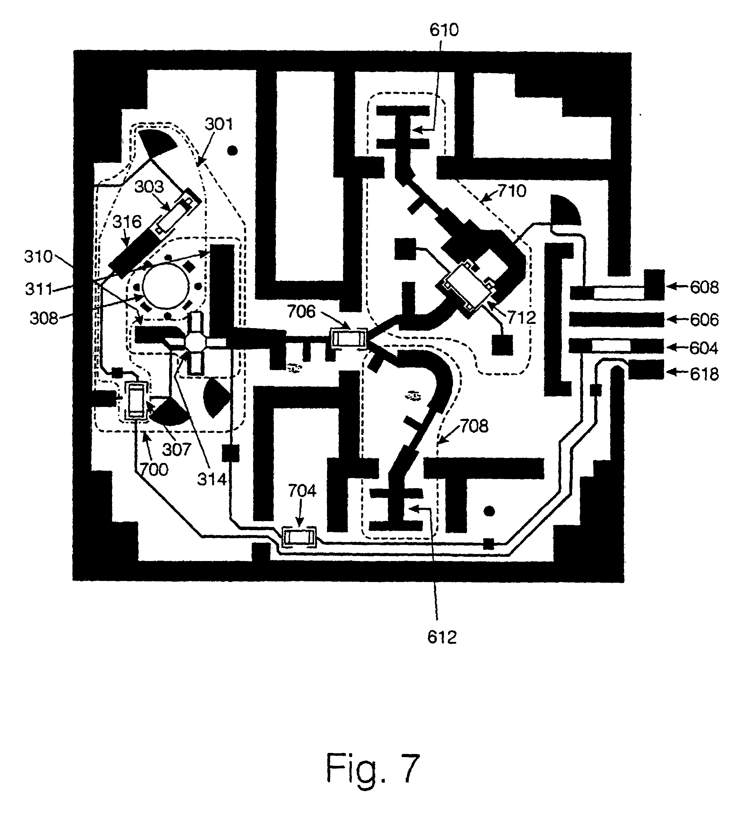

Figure 5 and 6 show the groundplane 500 and the component side circuitry 600 respectively of the microwave board. Figure 7 shows the component side of the microwave board 600 with the components mounted thereon. The oscillator circuit 700 is enclosed by the broken line. The oscillator circuit comprises a first 301 and second 302 electromagnetically couplable resonant circuits. The first resonant circuit comprises means for receiving a modulating voltage v(t) including a connection tab 702, a 1KOhm resistor 307, a forward biased Schottky diode 303 and a tuning line 316 electromagnetically couplable to the dielectric resonator 308.

The second circuit 302 comprises the dielectric resonator 308 coupled, via microstrip lines 310 and 311 to the gate and drain of a FHX35LPT transistor 314. Power is provided to the transistor 314 via a 39 Ohm resistor 704.

The output from the oscillator circuit 700 is fed via a decoupling capacitor 706 to the transmit 708 and receive 710 portions of the detector. The transmit portion 708 comprises a microstrip line 612 for coupling to the transmit antenna. Similarly, the receive portion 710 receives via microstrip line 610 a reflected version of the transmitted signal. The microwave board 600 and the antenna circuit board 400 are mounted back-to-back with the groundplane intervening. The alignment of the boards is such that the transmit array feed line 418 overlies the associated feed line 612 on the microwave board. Similarly, the receive array feed line 416 on the antenna board overlies the associated feed line 610 on the microwave board. Coupling between the microwave circuit board and the antenna board is achieved by the provision of two narrow slots 502 and 504 in the groundplane layer of the microwave board. The reflected signal and the output from the oscillator circuit are combined using a mixer diode 712, for example, a BAT15-099, to produce an IF signal which is output via connection tab 608.

## Claims

1. An oscillator circuit (300) comprising first (301) and second (302) mutually electromagnetically couplable resonant circuits, the second circuit (302) comprising a dielectric element (308) and excitation means (310,314,311) operable to produce a first frequency of oscillation, the first circuit (301) comprising the dielectric element (308), excitation means (316,303,307) including a Schottky diode (303) operable in a forward bias mode, responsive to an applied signal (322), to vary the resonant frequency of the first resonant circuit (301), and thereby vary the first frequency of oscillation of the oscillator circuit (300).

2. A circuit as claimed in claim 1, wherein the modes of resonance have associated coupling points on the excitation means (310,311) of the second circuit, and the excitation means (310,311) of the second circuit is arranged such that the coupling points are a substantially constant distance from the dielectric element (308).

3. A circuit as claimed in claim 2, wherein the dielectric element (308) comprises an arcuate profile and said excitation means are arranged to follow substantially the arcuate profile of the dielectric element 308.

4. A circuit as claimed in claim any preceding claim, wherein said excitation means (310,311,316) comprise excitation microstrip lines.

5. A motion detection device comprising an oscillator circuit as claimed in any preceding claim.

6. A microwave transmit/receive assembly comprising an oscillator as claimed in any of claims 1 to 5.

## Patentansprüche

1. Oszillatorschaltung (300) mit miteinander elektromagnetisch koppelbaren ersten (301) und zweiten (302) Resonanzschaltungen, wobei die zweite Schaltung (302) ein dielektrisches Element (308) und eine Anregungseinrichtung (310, 314, 311) aufweist, die zur Erzeugung einer ersten Oszillationsfrequenz betreibbar ist, wobei die erste Schaltung (301) das dielektrische Element (308) und eine Anregungseinrichtung (316, 303, 307) einschließlich einer Schottky-Diode (303) umfaßt, die in einem Durchlaßvorspannungsmodus in Reaktion auf ein angelegtes Signal (322) betreibbar ist, um die Resonanzfrequenz der ersten Resonanzschaltung (301) zu variieren und dadurch die erste Oszillationsfrequenz der Oszillatorschaltung (300) zu variieren.

2. Schaltung nach Anspruch 1, wobei die Resonanzmoden zugeordnete Kopplungspunkte auf der Anregungseinrichtung (310, 311) der zweiten Schaltung haben und wobei die Anregungseinrichtung (310, 311) der zweiten Schaltung so ausgestaltet ist, daß die Kopplungspunkte im wesentlichen ein konstantem Abstand von dem dielektrischen Element (308) sind.

3. Schaltung nach Anspruch 2, wobei das dielektrische Element (308) ein bogenförmiges Profil aufweist und die Anregungseinrichtungen so ausgestaltet sind, um im wesentlichen dem bogenförmigen Profil des dielektrischen Elements (308) zu folgen.

4. Schaltung nach einem der vorhergehenden Ansprüche, wobei die Anregungseinrichtung (310, 311, 316) Anregungs-Mikröstreifenleiter aufweist.

5. Bewegungsdetektorgerät mit einer Oszillatorschaltung nach einem der vorhergehenden Ansprüche.

6. Mikrowellen-Sende/Empfangs-Anordnung mit einem Oszillator nach einem der Ansprüche 1 bis 5.

## Revendications

1. Circuit(300) d'oscillateur comprenant des premier (301) et deuxième (302) circuits résonants pouvant être couplés mutuellement de manière électromagnétique, le deuxième circuit (302) comprenant un élément diélectrique (308) et des moyens (310, 314, 311) d'excitation pouvant fonctionner pour produire une première fréquence d'oscillation, le premier circuit (301) comprenant l'élément diélectrique (308), des moyens (316, 303, 307) d'excitation comprenant une diode Schottky (303) pouvant fonctionner dans un mode de polarisation directe, répondant à un signal appliqué (322) pour faire varier la fréquence de résonance du premier circuit résonant (301) et faire varier ainsi la première fréquence d'oscillation du circuit (300) d'oscillateur.

2. Circuit selon la revendication 1, dans lequel les modes de résonance ont des points associés de couplage sur les moyens (310, 311) d'excitation du deuxième circuit, et les moyens (310, 311) d'excitation du deuxième circuit sont disposés de sorte que les points de couplage soient à une distance pratiquement constante de l'élément diélectrique (308).

3. Circuit selon la revendication 2, dans lequel l'élément diélectrique (308) comprend un profil en forme d'arc et lesdits moyens d'excitation sont disposés pour suivre pratiquement le profil en forme d'arc de l'élément diélectrique (308).

4. Circuit selon l'une quelconque des revendications précédentes, dans lequel lesdits moyens (310, 311, 316) d'excitation comprennent des lignes d'excitation à microruban.

5. Dispositif de détection de mouvement comprenant un circuit d'oscillateur selon l'une quelconque des revendications précédentes.

6. Ensemble d'émission-réception hyperfréquence comprenant un oscillateur selon l'une quelconque des revendications 1 à 5.
